# EUROPEAN PATENT APPLICATION

(11) **EP 4 498 413 A2**
(43) Date of publication of application: **29.01.2025**
(21) Application number: 24185676.4
(22) Date of filing: 01.07.2024
(51) Int. Cl.: H01L 21/677

(54) **SUBSTRATE PROCESSING APPARATUS, TRANSFER METHOD, METHOD OF MANUFACTURING SEMICONDUCTOR DEVICE AND PROGRAM**

(30) Priority: 03.07.2023 JP 2023109648
(71) Applicant: Kokusai Electric Corp., Tokyo 1010045 (JP)
(72) Inventor: TANIKAWA, Risa, 939-2393 Toyama-shi (JP); KITAMOTO, Hiroyuki, 939-2393 Toyama-shi (JP); MORITA, Osamu, 939-2393 Toyama-shi (JP)
(74) Representative: Verscht, Thomas Kurt Albert

(57) **Abstract**

To accept a subsequent container regardless of a usage state of a transport structure and thereby to improve a transfer efficiency of a container, there is provided a technique that includes: a mounting structure on which a container provided with a door is placed; a storage structure for storing the container; a processing structure; a transport structure for transporting a substrate to the processing structure and including: an opening/closing structure opening or closing the door; and a checker for checking a state of the substrate in the container; a transfer structure for holding the container and transferring the container to the mounting structure, the storage structure and the transport structure; and a controller for controlling the transfer structure to hold the container on the mounting structure and the mounting structure to accept a placement of a subsequent container, regardless of a usage state of the transport structure.

## Description

### [Technical Field]

The present disclosure relates to a substrate processing apparatus, a transfer method, a method of manufacturing a semiconductor device and a program.

### [Related Art]

According to Patent Document 1, a substrate processing apparatus may include: a storage container in which a plurality of substrates can be stored; a mounting structure (placing structure) on which the storage container is placed; a transfer device configured to transfer the storage container; a mapping device serving as a substrate state detector; and a transport structure (for example, an opener) through which the plurality of substrates can be loaded and unloaded.

### [Related Art]

### [Patent document]

Patent Document 1: Japanese Patent Laid-Open No. 2009-177195

### [Disclosure]

### [Technical Problem]

According to the present disclosure, there is provided a technique capable of accepting a subsequent container regardless of a usage state of a transport structure and thereby capable of improving a transfer efficiency of a container.

### [Technical Solution]

According to an embodiment of the present disclosure, there is provided a technique that includes a mounting structure on which a container provided with a door is placed, wherein the container is configured to accommodate a substrate; a storage structure configured to store the container; a processing structure configured to process the substrate; a transport structure configured to transport the substrate to the processing structure and including: an opening/closing structure configured to open or close the door; and a checker configured to check a state of the substrate accommodated in the container; a transfer structure configured to hold the container and to transfer the container to the mounting structure, the storage structure and the transport structure; and a controller configured to be capable of controlling the transfer structure to hold the container placed on the mounting structure and capable of controlling the mounting structure to accept a placement of a subsequent container, regardless of a usage state of the transport structure.

### [Advantageous Effects]

According to some embodiments of the present disclosure, it is possible to accept a subsequent container to be accepted regardless of a usage state of a transport structure and thereby to improve a transfer efficiency of a container.

### [Brief Description of Drawings]

FIG. 1 is a diagram schematically illustrating a perspective view of a substrate processing apparatus according to one or more embodiments of the present disclosure, wherein some components of the substrate processing apparatus are omitted.
FIG. 2 is a diagram schematically illustrating a vertical cross-section of the substrate processing apparatus according to the embodiments of the present disclosure.
FIG. 3 is a diagram schematically illustrating a vertical cross-section of a process furnace of the substrate processing apparatus according to the embodiments of the present disclosure.
FIG. 4 is a block diagram schematically illustrating a configuration of a controller and related components of the substrate processing apparatus according to the embodiments of the present disclosure.
FIG. 5 is a diagram schematically illustrating an exemplary screen displayed on a display included in the substrate processing apparatus according to the embodiments of the present disclosure.
FIG. 6 is a flow chart schematically illustrating operations performed by the controller of the substrate processing apparatus according to the embodiments of the present disclosure.

### [Detailed Description]

### <Embodiments of Present Disclosure>

Hereinafter, one or more embodiments (also simply referred to as "embodiments") according to the technique of the present disclosure will be described with reference to the drawings. In the drawings, the same or equivalent constituents are designated by the same reference numerals. In addition, dimensional ratios in the drawings may be exaggerated for convenience of explanation, and may differ from the actual ratios.

### <Configuration>

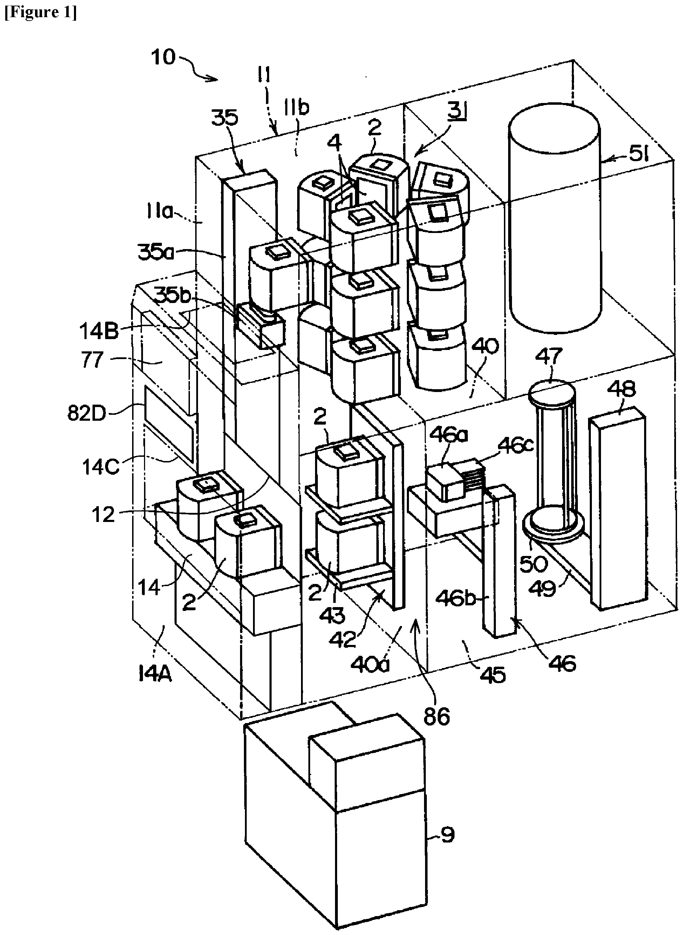

For example, a substrate processing apparatus 10 according to the present embodiments is configured as a batch type vertical diffusion and CVD (chemical vapor deposition) apparatus. As shown in FIGS. 1 to 3, the substrate processing apparatus 10 includes, a main housing 11 as a part of a housing, a subsidiary housing 40 and a front housing 14A. In addition, the substrate processing apparatus 10 further includes a display 82D and a controller 77. Further, in the present embodiments, a container 2 in which a wafer 1 serving as a substrate is stored is used.

The container 2 is substantially of a cubic box shape, and a wafer entrance (not shown) is provided on a side wall of the container 2. A door 4 serving as a lid capable of closing the wafer entrance is attached to the wafer entrance such that the door 4 can be attached or detached. A plurality of positioning holes (not shown) are provided on a lower surface of the container 2.

### <Main Housing>

As shown in FIGS. 1, 2 and 3, a front wall 11a of the main housing 11 of the substrate processing apparatus 10 constitutes a partition wall that partitions between an inside and an outside of the main housing 11. A container loading/unloading port 12 communicating between the inside and outside of the main housing 11 is provided at an intermediate height of the front wall 11a. The container 2 can be transferred (loaded) into the main housing 11 and transferred (unloaded) out of the main housing 11 through the container loading/unloading port 12. A front shutter 13 is configured to open or close the container loading/unloading port 12.

A loading port structure 14, which is an example of a mounting structure (placing structure), is provided on an outside of the front wall (partition wall) 11a of the main housing 11. The loading port structure 14 is located substantially directly below the container loading/unloading port 12. The loading port structure 14 constitutes a loading/unloading structure. The loading port structure 14 is configured to align the container 2 (which is placed thereon) with the container loading/unloading port 12. For example, two loading port structures including the loading port structure 14 may be provided in parallel. Hereinafter, each of the two loading port structures may also be referred to as the "loading port structure 14".

A container storage chamber 11b is provided at a front region (area) of the main housing 11. A rotatable container shelf 31, which is an example of a storage structure, is provided in the container storage chamber 11b. The rotatable container shelf 31 is arranged in an upper space of the container storage chamber 11b at a substantially central portion in a front-rear direction thereof. The rotatable container shelf 31 constitutes a storage shelf configured to store a plurality of containers including the container 2 within the housing. Hereinafter, the plurality of containers including the container 2 may also be simply referred to as "containers 2".

The rotatable container shelf 31 includes a support column 32 and a plurality of shelf plates 33. The support column 32 is vertically provided and is intermittently rotated within a horizontal plane. The plurality of shelf plates 33 are configured to be supported (or fixed) radially by the support column 32 at positions of an upper portion, a lower portion and a mid portion of the support column 32. The plurality of shelf plates 33 are configured such that the containers 2 can be placed on appropriate shelf plates among the plurality of shelf plates 33, respectively. Hereinafter, each of the plurality of shelf plates 33 may also be referred to as a "shelf plate 33".

A plurality of receiving kinematic pins 34 are protruded from an upper surface of the shelf plate 33, and the receiving kinematic pins 34 can be fitted into the positioning holes in the container 2, respectively.

A container transfer device 35 serving as an example of a transfer structure is installed in the container storage chamber 11b. The container transfer device 35 constitutes a transfer device capable of transferring the container 2 between the loading port structure 14 and the rotatable container shelf 31 via the container loading/unloading port 12.

The container transfer device 35 is constituted by a container elevator 35a serving as a storage container elevating structure and a container transfer structure 35b serving as a storage container transfer structure. The container transfer structure 35b is provided with a holder (also referred to as a "holding structure") capable of holding (or supporting) the lower surface of the container 2.

By consecutive operations of the container elevator 35a and the container transfer structure 35b, the container transfer device 35 transfers the container 2 among a support table 18, the rotatable container shelf 31 and a placement table (also referred to as a "mounting table") 43 of a container opener 42, which will be described later.

### <Front Housing>

The front housing 14A is provided in front of the front wall 11a of the main housing 11. The front housing 14A is provided to surround the loading port structure 14 and an upper space thereof. A ceiling opening 14B is provided in a ceiling wall of the front housing 14A, and a front opening 14C is provided in a front wall of the front housing 14A. That is, the loading port structure 14 is capable of receiving the container 2 via the front opening 14C, and is also capable of receiving the container 2 from the container transfer structure (also referred to as an "OHT" (Overhead Hoist Transfer)) 35b via the ceiling opening 14B.

The container 2 is loaded onto the loading port structure 14 by an in-process transfer device (also referred to as an "inter-process transfer device") located outside the substrate processing apparatus 10 (that is, outside the housing), and is also unloaded out of the loading port structure 14.

The in-process transfer device may be configured as a device such as a floor-traveling-type in-plant transfer vehicle (hereinafter referred to as an "AGV" (automated guided vehicle)) 9 shown in FIG. 1 and a ceiling-traveling-type in-plant transfer device. One of the devices exemplified above may be used as the in-process transfer device.

For example, a transfer method of the container 2 is not limited to those described above. For example, a container transfer device capable of handling the container 2 by gripping an upper portion thereof may be used. In such a case, the container 2 is loaded into the loading port structure 14 exclusively through the ceiling opening 14B.

Further, as shown in FIG. 1, the controller 77 described later is installed inside the front housing 14A.

### <Subsidiary Housing>

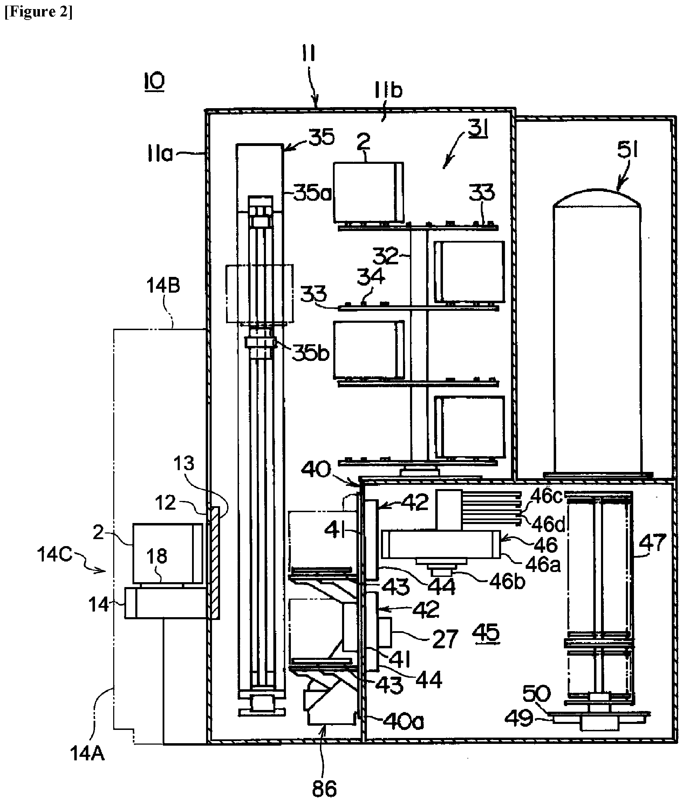

As shown in FIG. 2, the subsidiary housing 40 is provided in the main housing 11 at a lower portion thereof and at a substantially center portion of the main housing 11 in the front-rear direction to extend toward a rear end of the substrate processing apparatus 10. The subsidiary housing 40 is provided with a transport structure 86.

A pair of wafer loading/unloading ports 41 through which the wafer 1 is loaded into or unloaded out of the subsidiary housing 40 are provided at a front wall 40a of the subsidiary housing 40. The pair of wafer loading/unloading ports 41 are arranged vertically in two stages. A pair of container openers including the container opener 42 are provided at the pair of wafer loading/unloading ports 41, respectively. Hereinafter, each of the pair of wafer loading/unloading ports 41 may also be referred to as a "wafer loading/unloading port 41", and the pair of container openers including the container opener 42 may also be simply referred to as "container openers 42". For example, an upper container opener and a lower container opener may be provided as the container openers 42. The upper container opener and the lower container opener may also be referred to as the "container opener 42". The wafer loading/unloading port 41 is configured such that the wafer 1 is capable of being loaded into and out of the subsidiary housing 40 through the wafer loading/unloading port 41.

The subsidiary housing 40 constitutes a preliminary chamber 45, and the preliminary chamber 45 is fluidly isolated from the container storage chamber 11b in which the container transfer device 35 and the rotatable container shelf 31 are installed.

A wafer transport structure 46 is provided at a front region of the preliminary chamber 45. For example, the wafer transport structure 46 includes a wafer transport device 46a, a wafer transport device elevator 46b and tweezers 46c. The tweezers 46c constitute a mounting structure for the wafer 1. The wafer transport device 46a is configured to rotate and linearly move the tweezers 46c holding the wafer 1 in a horizontal plane. The wafer transport device elevator 46b is installed at a right end of the front region of the preliminary chamber 45. The wafer transport device elevator 46b is configured to elevate and lower the wafer transport device 46a.

The transport structure 86 according to the present embodiments includes a mapping device 27, the container opener 42 and the wafer transport structure 46. In the transport structure 86, the container opener 42, the mapping device 27 and the wafer transport structure 46 are arranged in this order from a front side of the substrate processing apparatus 10.

The container opener 42, which is an example of an opening/closing structure according to the present embodiments, includes: the placement table 43 on which the container 2 is placed; and an attachment/detachment structure 44 configured to attach and detach the door 4 of the container 2. The container opener 42 is configured to open or close the wafer entrance of the container 2 by detaching or attaching the door 4 of the container 2 placed on the placement table 43 using the attachment/detachment structure 44.

The container opener 42 constitutes a sealed housing capable of remaining filled with an inert gas such as nitrogen gas. The container opener 42 is configured to be capable of supplying the nitrogen gas through a nitrogen gas supplier (which is a nitrogen gas supply structure) (not shown) and exhausting the nitrogen gas through an exhauster (which is an exhaust structure) (not shown).

The mapping device 27, which is an example of a checker according to the present embodiments, includes: a linear actuator serving as a driving source; a holder; and a plurality of detectors. The holder of the mapping device 27 is configured to be moved back and forth with respect to the wafer entrance of the container 2 by the linear actuator. The plurality of detectors are held (supported) in the holder of the mapping device 27. By using the plurality of detectors, the mapping device 27 is configured to be capable of detecting whether or not the wafers 1 are respectively held in a plurality of slots in the container 2.

By consecutive operations of the wafer transport device elevator 46b and the wafer transport device 46a, the wafer transport structure 46 is configured to transfer the wafer 1 held by the tweezers 46c from the container 2 to a boat 47, and to load the wafer 1 transferred in a manner described above onto the boat 47.

Further, the wafer transport structure 46 is configured to unload the wafer 1 from the boat 47 by holding the wafer 1 with the tweezers 46c, to transfer the wafer 1 from the boat 47 to the container 2, and to return the wafer 1 to the container 2.

A boat elevator 48 capable of elevating and lowering the boat 47 is provided at a rear region (area) of the preliminary chamber 45.

A seal cap 50 is horizontally installed on an arm 49 (which serves as a coupling structure connected to an elevating platform of the boat elevator 48). The seal cap 50 supports the boat 47 vertically, and is capable of closing a lower end portion of a process furnace 51 (which is an example of a processing structure).

The boat 47 includes a plurality of holding structures. The boat 47 is configured to horizontally hold the wafers 1 (for example, 50 to 125 wafers) with their centers aligned in a vertical direction.

Although not shown for convenience, a clean gas supplier (which is a clean gas supply structure) is provided at a left end of the preliminary chamber 45 in a manner opposite to the wafer transport device elevator 46b and the boat elevator 48. The clean gas supplier is constituted by a supply fan (now shown) and a dust filter (now shown). The clean gas supplier is configured to supply clean air, which is a purified atmosphere or an inert gas.

Further, a notch alignment device (not shown) is provided between the wafer transport device 46a and the clean air supplier. The notch alignment device constitutes a substrate alignment device configured to align a circumferential position of the wafer 1.

The clean air ejected from the clean air supplier is circulated in the notch alignment device, the wafer transport device 46a and the boat 47, and then sucked into a duct (not shown). Thereafter, the clean air sucked into the duct is exhausted out of the main housing 11, or is circulated to a primary side (that is, a supply side) (which is a suction side of the clean air supplier), and is ejected again into the preliminary chamber 45 by the clean air supplier.

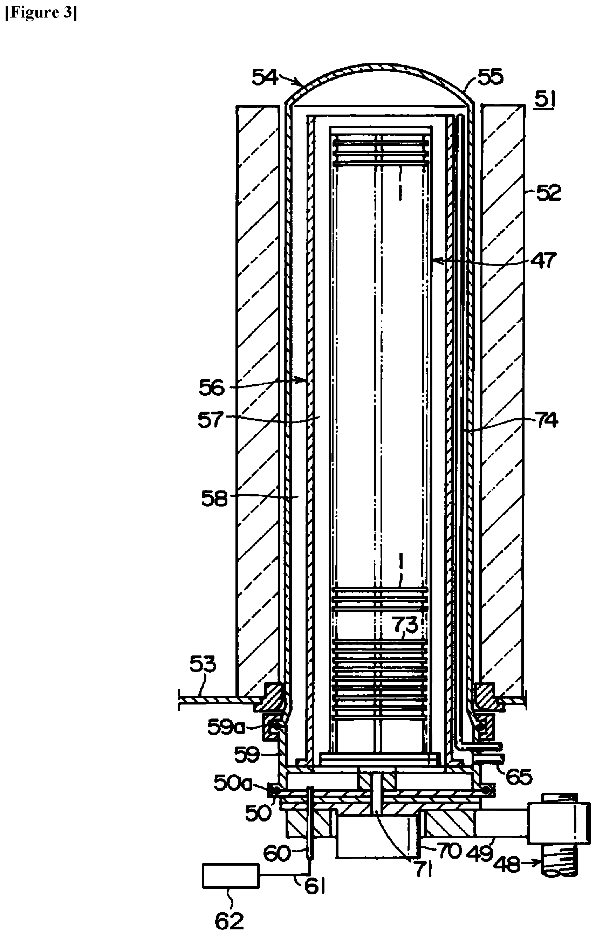

The process furnace 51 shown in FIG. 3 is provided above the subsidiary housing 40. As shown in FIG. 3, the process furnace 51 includes a heater 52 serving as a heating structure.

The heater 52 is of a cylindrical shape, and is vertically installed while being supported by a heater base 53 serving as a support plate.

A process tube 54 serving as a reaction tube is provided in an inner side of the heater 52 to be aligned in a manner concentric with the heater 52. For example, the process tube 54 is constituted by an outer tube 55 serving as an outer reaction tube and an inner tube 56 serving as an inner reaction tube provided inside the outer tube 55.

For example, the outer tube 55 is made of a heat resistant material such as quartz (SiO₂) and silicon carbide (SiC). For example, the outer tube 55 is of a cylindrical shape with a closed upper end and an open lower end, and an inner diameter of the outer tube 55 is set to be greater than an outer diameter of the inner tube 56. The outer tube 55 is provided to be aligned in a manner concentric with the inner tube 56.

For example, the inner tube 56 is made of a heat resistant material such as quartz and silicon carbide. For example, the inner tube 56 is of a cylindrical shape with open upper and lower ends. A hollow cylindrical portion of the inner tube 56 constitutes a process chamber 57. The process chamber 57 is configured such that the boat 47 can be accommodated in the process chamber 57 while the wafers 1 are held and aligned in the boat 47 in a horizontal orientation and a vertical arrangement in a multistage manner.

A gap between the outer tube 55 and the inner tube 56 constitutes a cylindrical space 58.

A manifold 59 is provided under the outer tube 55 to be aligned in a manner concentric with the outer tube 55. For example, the manifold 59 is made of a metal material such as stainless steel (SUS). For example, the manifold 59 is of a cylindrical shape with open upper and lower ends. The manifold 59 engages with the outer tube 55 and the inner tube 56, and supports the outer tube 55 and the inner tube 56.

By supporting the manifold 59 by the heater base 53, the process tube 54 is installed vertically.

A reaction vessel is constituted by the process tube 54 and the manifold 59.

An O-ring 59a serving as a seal is provided between the manifold 59 and the outer tube 55.

A nozzle 60 serving as a gas introduction structure is connected to the seal cap 50, and the nozzle 60 communicates with an inside of the process chamber 57. A gas supply pipe 61 is connected to the nozzle 60.

A gas supply source (not shown) is connected to the gas supply pipe 61 via a mass flow controller (MFC) 62 on a location (that is, on an upstream side) in a manner opposite to a location connected to the nozzle 60. The MFC 62 constitutes a gas flow rate controller 64. The gas supply source (not shown) is configured to supply a desired gas such as a process gas and the inert gas.

A driving controller 72 is electrically connected to a rotator (which is a rotating structure) 70 and the boat elevator 48 by an electrical wiring. The driving controller 72 is configured to control the rotator 70 and the boat elevator 48 at a desired timing to perform a desired operation.

For example, the boat 47 is made of a heat resistant material such as quartz and silicon carbide. The boat 47 is configured such that the wafers 1 are held (or accommodated) in the vertical direction in the boat 47 while the wafers 1 are horizontally oriented with their centers aligned with one another in a multistage manner.

For example, a plurality of heat insulation plates 73 are provided at a lower portion of the boat 47 while the heat insulation plates 73 are aligned (supported) in a horizontal orientation in a multistage manner. For example, each of the heat insulation plates 73 is of a disk shape, and is made of a heat resistant material such as quartz and SiC. A heat insulator (which is a heat insulating structure) is constituted by the heat insulation plates 73. With such a configuration, the heat insulation plates 73 suppress a transmission of the heat from the heater 52 to the manifold 59.

A temperature sensor 74 is installed in the process tube 54. A temperature detector is constituted by the temperature sensor 74. A temperature controller 75 is electrically connected to the heater 52 and the temperature sensor 74 by an electrical wiring.

The preliminary chamber 45 is filled with the nitrogen gas as the clean air. In such a state, for example, an oxygen concentration in the preliminary chamber 45 is set to be 20 ppm or less, which is much lower than an oxygen concentration in an atmospheric atmosphere inside the main housing 11.

Alternatively, the container 2 loaded into the main housing 11 from the container loading/unloading port 12 by the container transfer structure 35b may be directly transferred to the container opener 42 installed at the wafer loading/unloading port 41.

### <Controller>

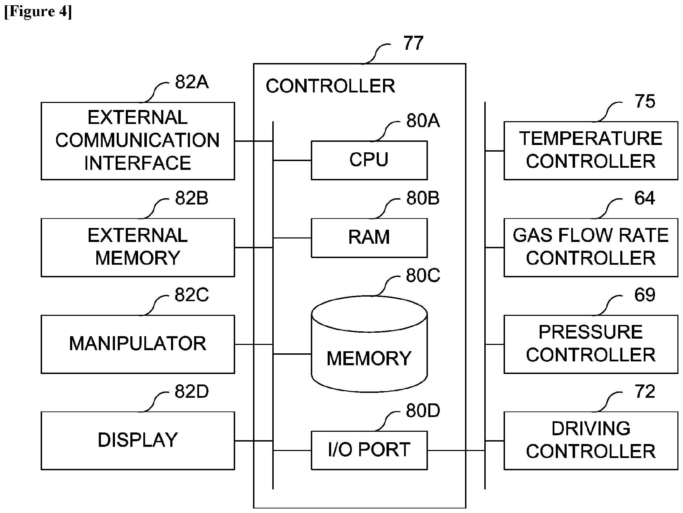

As shown in FIG. 4, the controller 77 includes a CPU 80A, a RAM 80B, a memory 80C and an input/output device (I/O port) 80D. The I/O port 80D is connected to the temperature controller 75, the gas flow rate controller 64, a pressure controller 69 and the driving controller 72. Further, the controller 77 is connected to an external communication interface 82A, an external memory 82B, a manipulator 82C and the display 82D. Via the I/O port 80D, the controller 77 is configured to control an entirety of operations of components (in the substrate processing apparatus 10) such as the loading port structure 14, the mapping device 27, the rotatable container shelf 31, the container transfer device 35, the container opener 42 and the wafer transport structure 46. That is, the controller 77 is configured to be capable of controlling the components in the substrate processing apparatus 10 such that the container 2 is transferred to the rotatable container shelf 31, the transport structure 86 or the loading port structure 14. Further, the controller 77 is configured to control the nitrogen gas supplier (not shown) and the exhauster (not shown).

The gas flow rate controller 64 is electrically connected to the MFC 62 by an electrical wiring. The gas flow rate controller 64 is configured to control the MFC 62 such that a flow rate of a gas to be supplied reaches and is maintained at a desired amount at a desired timing.

The manifold 59 is provided with an exhaust pipe 65 through which an inner atmosphere of the process chamber 57 is exhausted. The exhaust pipe 65 is disposed at a lower end portion of the cylindrical space 58, and communicates with the cylindrical space 58.

The exhauster (not shown) is connected to the exhaust pipe 65 via a pressure sensor (not shown) and a pressure regulator (which is a pressure adjusting structure) (not shown) on a location (that is, on a downstream side) in a manner opposite to a location connected to the manifold 59. A pressure detector is constituted by the pressure sensor (not shown). The exhauster is constituted by components such as a vacuum pump. The pressure sensor (not shown), the pressure regulator (not shown) and the exhauster (not shown) exhaust the inside of the process chamber 57 such that an inner pressure of the process chamber 57 reaches and is maintained at a predetermined pressure (that is, a predetermined vacuum degree).

The pressure controller 69 is electrically connected to the pressure regulator (not shown) and the pressure sensor (not shown) by an electrical wiring. The pressure controller 69 is configured to control the pressure regulator (not shown) based on a pressure detected by the pressure sensor (not shown) such that the inner pressure of the process chamber 57 reaches and is maintained at a desired pressure at a desired timing.

By adjusting a state of electric conduction to the heater 52 based on temperature information detected by the temperature sensor 74, the temperature controller 75 is configured to control the heater 52 such that a desired temperature distribution of an inner temperature of the process chamber 57 can be obtained at a desired timing.

The seal cap 50 contacts the lower end of the manifold 59 from thereunder in the vertical direction. A furnace opening lid capable of airtightly sealing (closing) a lower end opening of the manifold 59 is constituted by the seal cap 50.

For example, the seal cap 50 is made of a metal material such as stainless steel (SUS), and is of a disk shape. An O-ring 50a serving as a seal is provided on an upper surface of the seal cap 50. The O-ring 50a is in contact with the lower end of the manifold 59.

The rotator 70 configured to rotate the boat 47 accommodating the wafers 1 is provided at the seal cap 50 in a manner opposite to the process chamber 57. A rotating shaft 71 of the rotator 70 is connected to the boat 47 through the seal cap 50. As the rotating shaft 71 of the rotator 70 rotates the boat 47, the wafers 1 are rotated.

Further, the controller 77 of the substrate processing apparatus 10 according to the present embodiments is connected to an external equipment (not shown) via the external communication interface 82A. The external equipment is configured to be capable of communicating with the controller 77 via the external communication interface 82A, and various information is reported from the controller 77 to the external equipment. For example, a placement acceptance state of the container 2 to the mounting structure is reported from the controller 77 to the external equipment. Further, when information is reported from the controller 77, the external equipment returns (or transmits) response information.

### <Display 82D>

As shown in FIG. 1, the display 82D is attached to a portion above the front opening 14C. For example, the display 82D is configured as a liquid crystal display, and contents to be displayed by the display 82D are controlled by the controller 77.

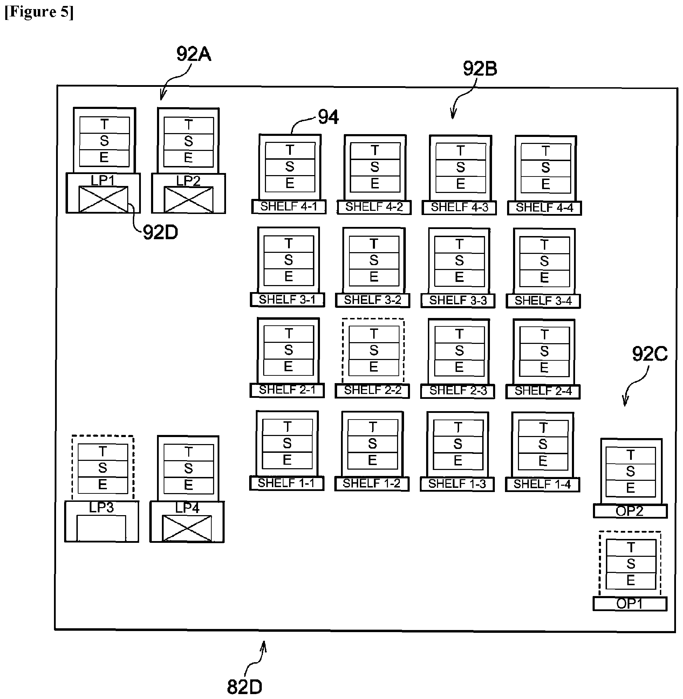

Further, the CPU 80A according to the present embodiments executes an operation of controlling a screen display of the display 82D. Thereby, as shown in FIG. 5, it is possible to display, on the display 82D, the number of the containers 2 stored inside the main housing 11 and states of the containers 2 stored inside the main housing 11.

More specifically, as shown in FIG. 5, the CPU 80A displays a plurality of loading port structure objects 92A, a plurality of storage shelf objects 92B and a plurality of opener objects 92C on a screen of the display 82D. On the loading port structure objects 92A, the storage shelf objects 92B and the opener objects 92C, icons 94 may be respectively displayed in a manner corresponding to the presence or absence and the state of the container 2 related thereto inside the housing. Hereinafter, each of the loading port structure objects 92A may also be referred to as a "loading port structure object 92A", each of the storage shelf objects 92B may also be referred to as a "storage shelf object 92B", each of the opener objects 92C may also be referred to as an "opener object 92C", and each of the icons 94 may also be referred to as an "icon 94".

More specifically, when the container 2 is placed on the loading port structure 14, the icon 94 is displayed on the loading port structure object 92A related thereto. Further, when the container 2 is placed on the shelf plate 33, the icon 94 is displayed on the storage shelf object 92B related thereto. Further, when the container 2 is placed on the placement table 43, the icon 94 is displayed on the opener object 92C related thereto.

Further, as shown in FIG. 5, for example, a type ("T" in FIG. 5) of the wafers 1 accommodated in the container 2, states ("S" in FIG. 5) of the wafers 1 accommodated in the container 2 and whether or not a substrate processing for the wafers 1 can be executed ("E" in FIG. 5) may be displayed on the icon 94. More specifically, the type of the wafers 1 displayed on the icon 94 may indicate whether the wafers 1 serving as the substrates accommodated in the container 2 are used as a source material for a semiconductor device or are used as a dummy used for the substrate processing. Further, the states of the wafers 1 displayed on the icon 94 may indicate whether the substrate processing for the wafers 1 has been completed or not. Further, as an indication of whether or not the substrate processing for the wafers 1 can be executed the icon 94 may indicate whether a mapping has been completed or has not been executed. In other words, according to the present embodiments, state information of the container 2 is displayed by the icon 94. In addition, according to the present embodiments, in each of the loading port structure 14, the rotatable container shelf 31 and the transport structure 86, the icon 94 is not displayed but the absence of the container 2 is indicated at a location where the container 2 is not located.

For example, as shown in FIG. 5, display items of the loading port structure object 92A may be different from display items of the storage shelf object 92B and display items of the opener object 92C. Specifically, as shown in FIG. 5, when the loading port structure 14 is in use, a mark 92D indicating that the loading port structure 14 is in use is further displayed on the loading port structure object 92A. That is, the loading port structure 14 on which the mark 92D is displayed is not capable of accepting a placement of the container 2.

Subsequently, a state in which the container 2 is mapped in the transport structure 86 will be described. When the container 2 is placed on the placement table 43 of the transport structure 86, the wafer entrance of the container 2 is opened by the container opener 42. Then, the mapping device 27 is inserted into the wafer entrance of the container 2, and the mapping device 27 maps the wafers 1 inside the container 2.

After a predetermined mapping is completed, the mapping device 27 is returned to an original standby position thereof from the wafer entrance. Thereafter, the container opener 42 closes the wafer entrance.

For example, when mapping information read by the mapping device 27 differs from mapping information provided in advance for the container 2 (that is, a container to be read), the container 2 in which such difference is found is returned to the loading port structure 14. Then, the container 2 is immediately transferred from the loading port structure 14 for a process such as a wafer establishment process or an immediately preceding process by the in-process transfer device such as the AGV 9 shown in FIG. 1.

Subsequently, a method of manufacturing a semiconductor device according to the embodiments of the present disclosure will be described using the substrate processing apparatus 10 described above. The method of manufacturing the semiconductor device according to the present embodiments may include: a procedure of placing the container 2 on the mounting structure; a procedure of transferring the container 2 to the rotatable container shelf 31 or the transport structure 86; and a procedure (method) of forming a film by a CVD method. In addition, in the following description, the operations of the components constituting the substrate processing apparatus 10 are controlled by the controller 77.

### <Method of Manufacturing Semiconductor Device>

### <Procedure of Placing Container on Mounting Structure>

As shown in FIGS. 1 to 3, when the in-process transfer device loads the container 2 into the loading port structure 14 via the front opening 14C or the ceiling opening 14B, the container 2 is placed on the support table 18.

In the present step, the receiving kinematic pins 34 of the support table 18 are fitted into the positioning holes on the lower surface of the container 2, respectively, such that the container 2 is positioned on the support table 18.

The container loading/unloading port 12 is opened by the front shutter 13.

Subsequently, the container transfer structure 35b passes through the container loading/unloading port 12. Thereby, the container 2 supported by the support table 18 is transferred to the container transfer structure 35b of the container transfer device 35. That is, the container 2 is transferred between the support table 18 and the container transfer structure 35b.

The container 2 supported by the container transfer structure 35b is loaded into the main housing 11 through the container loading/unloading port 12.

As shown in FIGS. 1 and 2, the container 2 loaded into the main housing 11 is automatically transferred and delivered to a designated shelf plate 33 (among the shelf plates 33) of the rotatable container shelf 31 by the container transfer device 35.

In such a state, the receiving kinematic pins 34 of the shelf plate 33 are fitted into the positioning holes on the lower surface of the container 2, respectively, such that the container 2 is positioned on the shelf plate 33.

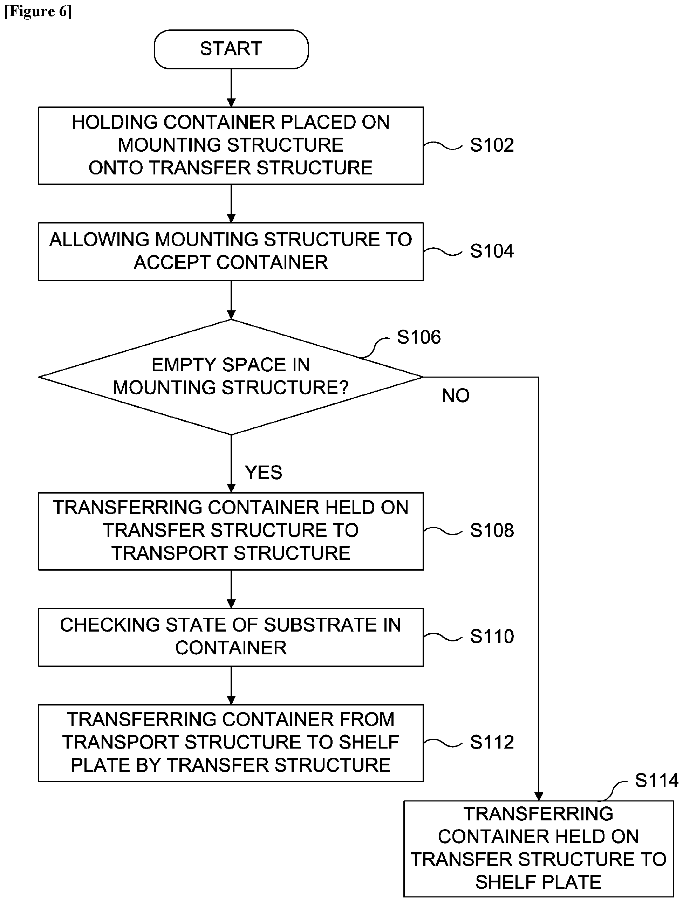

Hereinafter, an operation of transferring the container 2 placed on the mounting structure according to the present embodiments to the rotatable container shelf 31 or the transport structure 86 will be described with reference to FIG. 6.

### <Procedure of Transferring Container to Rotatable Container Shelf or Transport Structure>

The CPU 80A of the controller 77 loads the program stored in the memory 80C into the RAM 80B and performs various control operations. Subsequently, in the present embodiments, an operation performed by the CPU 80A when the container 2 is placed in the loading port structure 14 will be described with reference to FIG. 6. Further, the CPU 80A performs the procedure after confirming (or checking) that there is a shelf (among the rotatable container shelf 31) on which no container 2 is placed. That is, as shown in FIG. 6, the procedure is started in a state that there exists a location of the loading port structure object 92A where the icon 94 is not displayed and there also exists a location of the storage shelf object 92B where the icon 94 is not displayed.

First, in a step S102, when the CPU 80A recognizes that the container 2 is placed on the loading port structure 14, the CPU 80A restricts opening of the front opening 14C in front of the loading port structure 14. Then, the container transfer device 35 is driven to hold the container 2 placed on the loading port structure 14. Then, the loading port structure 14 pulls the container 2 held thereon into the main housing 11. In other words, when the CPU 80A recognizes that the container 2 is placed on the loading port structure 14, the CPU 80A causes (or controls) the container transfer device 35 to hold the container 2. Thereby, an empty space is created in the loading port structure 14. Further, the CPU 80A displays the icon 94 in the loading port structure object 92A (among the loading port structure objects 92A) of the display 82D at a location corresponding to the loading port structure 14 where the container 2 is placed. Thereafter, the CPU 80A performs a step S104.

In the step S104, the CPU 80A allows the loading port structure 14 to accept the container 2. More specifically, the CPU 80A causes the container transfer device 35 to hold the container 2 placed on the loading port structure 14, regardless of a usage state of the transport structure 86, such that a step of accepting a placement of a subsequent container (among the containers 2) onto the placement table 43 can be performed. For example, the CPU 80A allows an operating personnel to open the front opening 14C such that the external equipment (not shown) can be connected via the external communication interface 82A. By reporting to the external equipment that the container 2 can be accepted at the loading port structure 14, the CPU 80A allows the operating personnel to continue placing a new container (among the containers 2) at the loading port structure 14. Further, the CPU 80A hides the icon 94 in the loading port structure object 92A (among the loading port structure objects 92A) on the display 82D at the location corresponding to the loading port structure 14 where the container 2 was placed. Thereafter, the CPU 80A performs a step S106.

Further, in step the S106, the CPU 80A checks whether an empty space for the container 2 is present in the transport structure 86, that is, whether the container 2 is capable of being transferred to the transport structure 86. When it is determined positively in the step S106, that is, when it is determined that the transport structure 86 can be used (that is, the transport structure 86 is available), the CPU 80A performs a step S108. On the other hand, when it is determined negatively in the step S106, that is, when it is determined that the transport structure 86 cannot be used (that is, the transport structure 86 is unavailable), the CPU 80A performs a step S114. In addition, according to the present embodiments, the CPU 80A sends a report of the usage state of the transport structure 86 to the external equipment (not shown) via the external communication interface 82A, regardless of whether it is determined positively or negatively in the step S106. Then, the CPU 80A performs the step S108 or the step S114 without waiting for a response from the external equipment with respect to the report of the usage state of the transport structure 86.

Further, in the step S108, the CPU 80A causes the container transfer device 35 to transfer the container 2 held thereon to an empty placement table 43 among a plurality of placement tables 43 of the transport structure 86. In other words, the CPU 80A performs a step of transferring the container 2 (which is placed on the loading port structure 14 and provided with the door 4) in which the wafers 1 are accommodated to the transport structure 86 (which opens and closes the door 4 and checks the states of the wafers 1 accommodated in the container 2). Further, the CPU 80A displays the icon 94 in the opener object 92C (among the opener objects 92C) of the display 82D at a location corresponding to the placement table 43 on which the container 2 is placed. Thereafter, the CPU 80A performs a step S110.

Further, in the step S110, the CPU 80A checks the states of the wafers 1 (substrates) inside the container 2. More specifically, the CPU 80A controls the container opener 42 to cause the container opener 42 to open the door 4 of the container 2. Further, the CPU 80A controls the mapping device 27 to check the states of the wafers 1 accommodated in the container 2. Then, the CPU 80A receives the states of the wafers 1 accommodated in the container 2 from the mapping device 27, and causes the container opener 42 to close the door 4 of the container 2. Thereafter, the CPU 80A performs a step S112.

For example, a sensor 46d serving as a checker may be provided at a front end (tip) of the tweezers 46c of the wafer transport structure 46, and the CPU 80A may check the states of the wafers 1 accommodated in the container 2 using the sensor 46d.

Further, in the step S112, the CPU 80A causes the container transfer device 35 to transfer the container 2 (after the states of the wafers 1 accommodated therein are checked) from the transport structure 86 to the shelf plate 33 (where there is an empty space) of the rotatable container shelf 31. Further, the CPU 80A hides the icon 94 in the opener object 92C (among the opener objects 92C) on the display 82D at the location corresponding to the placement table 43 on which the container 2 was placed. Further, the CPU 80A displays the icon 94 in the storage shelf object 92B (among the storage shelf objects 92B) on the display 82D at the location corresponding to the shelf plate 33 on which the container 2 is placed. Thereafter, the CPU 80A terminates a transfer flow of the container 2.

Further, in the step S114, the CPU 80A causes the container transfer device 35 to transfer the container 2 (which has been pulled in from the loading port structure 14) from the transport structure 86 to the shelf plate 33 (where there is an empty space) of the rotatable container shelf 31. Further, the CPU 80A hides the icon 94 in the loading port structure object 92A (among the loading port structure objects 92A) on the display 82D at the location corresponding to the loading port structure 14 where the container 2 was placed. Further, the CPU 80A displays the icon 94 in the storage shelf object 92B (among the storage shelf objects 92B) on the display 82D at the location corresponding to the shelf plate 33 on which the container 2 is placed. Thereafter, the CPU 80A terminates the transfer flow of the container 2.

The procedure described above is described by way of an example in which the CPU 80A performs the procedure when there is an empty space on the rotatable container shelf 31. When there is no empty space on the rotatable container shelf 31, the procedure described above may not be performed. That is, it is also possible to configure the CPU 80A to perform the procedure described above only when there is one or more empty spaces on the rotatable container shelf 31. In such a case, when the container 2 is placed in the loading port structure 14, the CPU 80A may perform a procedure similar to the procedure described above after pulling the container 2 into the housing except for a step of allowing the loading port structure 14 to accept the container 2 (as in the step S104).

Further, in the procedure described above, for example, the CPU 80A stores a position of the container 2 (which is not transferred to the transport structure 86 but directly transferred to the rotatable container shelf 31) in the memory 80C. In other words, the CPU 80A stores the position of the container 2 (where the states of the wafers 1 accommodated therein are not checked) in the memory 80C. In such a case, in a separate procedure from the procedure described above, when the CPU 80A confirms that there is an empty space in the transport structure 86, when the CPU 80A transfers the container 2 (where the states of the wafers 1 accommodated therein are not checked) from the rotatable container shelf 31 to the transport structure 86 in a manner similar to the step S108 described above. Thereafter, by performing the step S110 and the step S112, the CPU 80A checks the states of the wafers 1 accommodated in the container 2.

In a manner described above, the container 2 is temporarily stored on the shelf plate 33, and waits on the shelf plate 33 until the wafers 1 accommodated in the container 2 are processed.

The container 2 is transferred from the shelf plate 33 to one of the container openers 42 (that is, one of the upper container opener and the lower container opener) by the container transfer device 35, and transferred to the placement table 43.

When transferring the container 2, the wafer loading/unloading port 41 of the container opener 42 is closed by the attachment/detachment structure 44, and the clean air is circulated through the preliminary chamber 45 until the preliminary chamber 45 is filled with the clean air.

An opening side end surface of the container 2 placed on the placement table 43 is pressed against an opening edge of the wafer loading/unloading port 41 on the front wall 40a. Subsequently, the door 4 is removed by the attachment/detachment structure 44, and the wafer entrance of the container 2 is opened.

When the container 2 is opened by the container opener 42, the wafer transport device 46a picks up the wafer 1 from the container 2 through the wafer entrance using the tweezers 46c. When the wafer 1 is picked up by the tweezers 46c, the wafer transport device 46a transfers the wafer 1 to the notch alignment device (not shown). The notch alignment device aligns the wafer 1. After the wafer 1 is aligned, the wafer transport device 46a picks up the wafer 1 from the notch alignment device using the tweezers 46c, and transfers the wafer 1 to the boat 47. That is, the wafer transport device 46a charges (or loads) the wafer 1 transferred as described above into the boat 47.

After the wafer 1 is charged into the boat 47, the wafer transport device 46a returns to the container 2 and charges a subsequent wafer (among the wafers 1) into the boat 47.

While the wafer transport structure 46 loads the wafer 1 into the boat 47 through the one of the container openers 42 (that is, one of the upper container opener and the lower container opener), another container 2 among the containers 2 is transferred from the rotatable container shelf 31 by the container transfer device 35 to the other one of the container openers 42. In the other one of the container openers 42, an operation of opening the container 2 by the other one of the container openers 42 is simultaneously performed.

When a predetermined number of wafers 1 are charged into the boat 47, the lower end portion of the process furnace 51 closed by a furnace opening shutter (not shown) is opened by the furnace opening shutter.

Subsequently, the boat 47 accommodating the wafers 1 is loaded (inserted) into the process furnace 51 by elevating the seal cap 50 by the boat elevator 48.

Hereinafter, the procedure (method) of forming the film by the CVD method using the process furnace 51 will be described. In addition, in the following description, operations of components constituting the process furnace 51 are controlled by the controller 77.

### <Procedure (Method) of Forming Film by CVD Method>

When the wafers 1 are charged into the boat 47, as shown in FIG. 3, the boat 47 accommodating the wafers 1 is elevated by the boat elevator 48 such that the boat 47 is loaded (inserted) into the process chamber 57.

In such a state, the seal cap 50 seals (or closes) the lower end of the manifold 59 via the O-ring 50a.

The inside of the process chamber 57 is exhausted by the exhauster (not shown) such that the inner pressure of the process chamber 57 reaches and is maintained at a desired pressure. When exhausting the inside of the process chamber 57, the inner pressure of the process chamber 57 is measured by the pressure sensor (not shown), and the pressure regulator (not shown) is feedback-controlled based on the pressure measured by the pressure sensor.

Further, the inside of the process chamber 57 is heated by the heater 52 such that the inner temperature of the process chamber 57 reaches and is maintained at a desired temperature. When heating the inside of the process chamber 57, the state of electric conduction to the heater 52 is feedback-controlled based on the temperature information detected by the temperature sensor 74 such that a desired temperature distribution of the inner temperature of the process chamber 57 can be obtained.

Subsequently, the boat 47 is rotated by the rotator 70. Thereby, the wafers 1 accommodated in the boat 47 are rotated.

Subsequently, the gas supplied from the gas supply source (not shown) and flows through the gas supply pipe 61, and is introduced into the process chamber 57 through the nozzle 60.

The gas introduced into the process chamber 57 flows upward in the process chamber 57, flows out through an upper end opening of the inner tube 56 into the cylindrical space 58, and is discharged (exhausted) through the exhaust pipe 65.

The gas comes into contact with the surface of the wafer 1 while passing through the process chamber 57. Thereby, the film is deposited on the surface of the wafer 1 by a thermal CVD reaction.

After a predetermined process time has elapsed, the inert gas is supplied from the gas supply source (not shown) through the gas supply pipe 61, and thereby, the inside of the process chamber 57 is replaced with the inert gas. Further, the inner pressure of the process chamber 57 is returned to the normal pressure (atmospheric pressure). In the present specification, the process time may refer to a time duration of continuously performing a process related thereto. The same also applies to the following description.

Thereafter, the seal cap 50 is lowered by the boat elevator 48 such that the lower end of the manifold 59 is opened. Further, the boat 47 with the wafers 1 (which are processed) accommodated therein is then transferred (unloaded) out of the process tube 54 through the lower end of the manifold 59.

After the boat 47 is unloaded, the wafers 1 (which are processed) are taken out from the boat 47 by the wafer transport device 46a and returned to an empty container (among the containers 2) that is previously transferred to the container opener 42.

When a predetermined number of the wafers 1 (which are processed) are stored, the door 4 is attached to the wafer entrance of the container 2 by the container opener 42.

The container 2 with the wafer entrance closed is automatically transferred and delivered to a designated shelf plate 33 (among the shelf plates 33) of the rotatable container shelf 31 by the container transfer device 35.

The container 2 is temporarily stored. Thereafter, when the front shutter 13 is opened, the container transfer device 35 transfers the container 2 from the shelf plate 33 (that is, the designated shelf plate 33) to the container loading/unloading port 12. Then, the container 2 is delivered to the support table 18 of the container elevator 35a with the container loading/unloading port 12 closed.

Alternatively, the container 2 with the wafers 1 (which are processed) stored therein may be directly transferred from the container opener 42 to the container loading/unloading port 12 by the container transfer device 35.

When the container 2 is delivered onto the support table 18, the front shutter 13 is closed. Further, a shaft (not shown) of the container elevator 35a is lowered onto the loading port structure 14 by an elevating driving structure (not shown).

The container 2 lowered onto the loading port structure 14 is transferred to a predetermined process by the in-process transfer device such as the AGV 9 shown in FIG. 1.

Subsequently, functions and effects obtained by the substrate processing apparatus 10 according to the present embodiments will be described. According to the present embodiments, it is possible to obtain one or more effects described below.

### <Functions and Effects>

According to the substrate processing apparatus 10 of the present embodiments, regardless of the usage state of the transport structure 86, the controller 77 causes the container transfer device 35 to hold the container 2 placed on the loading port structure 14. Thereby, it is possible to accept the placement of the subsequent container (among the containers 2) onto the loading port structure 14. As a result, it is possible to shorten a waiting time (stand-by time) for placing the container 2, and it is also possible to improve a processing efficiency of the wafers 1.

Further, according to the substrate processing apparatus 10 of the present embodiments, by completing the checking on the states of the wafers 1 accommodated in the container 2 stored on the rotatable container shelf 31, it is possible to perform a subsequent process.

Further, according to the substrate processing apparatus 10 of the present embodiments, by determining a transfer route in accordance with conditions, it is possible to smoothly transfer the containers 2 by the container transfer device 35.

Further, according to the substrate processing apparatus 10 of the present embodiments, the container transfer device 35 does not stand by while holding the container 2. Thereby, it is possible to smoothly perform a subsequent step.

Further, according to the substrate processing apparatus 10 of the present embodiments, by providing a route through which the container 2 is transferred from the rotatable container shelf 31 to the transport structure 86 and a route through which the container 2 is transferred from the loading port structure 14 to the transport structure 86, it is possible to eliminate waiting time of the transport structure 86 during the processing of the wafers 1.

Further, according to the substrate processing apparatus 10 of the present embodiments, it is possible to check the states of the wafers 1 accommodated in the container 2 without omission.

Further, according to the substrate processing apparatus 10 of the present embodiments, it is possible to prevent the containers 2 from colliding with each other at the loading port structure 14.

Further, according to the substrate processing apparatus 10 of the present embodiments, by reporting the presence or absence of a permission to place the container 2 on the loading port structure 14 to the external equipment (not shown), it is possible for the external equipment (not shown) to grasp a state of the loading port structure 14.

Further, according to the substrate processing apparatus 10 of the present embodiments, by reporting a state of the transport structure 86 (for example, the usage state of the transport structure 86) to the external equipment (not shown), it is possible for the external equipment (not shown) to instruct a subsequent operation (for example, a recovery operation for the container 2 and a start of the processing of the wafers 1).

Further, according to the substrate processing apparatus 10 of the present embodiments, by transferring the container 2 from the loading port structure 14 to the rotatable container shelf 31 without waiting for the response from the external equipment, it is possible to contribute to a reduction in the process time.

Further, according to the substrate processing apparatus 10 of the present embodiments, by storing a storage position of the container 2 and the state of the container 2, it is possible to easily grasp the container 2 stored on the rotatable container shelf 31.

Further, according to the substrate processing apparatus 10 of the present embodiments, by displaying the states of the containers 2 in each of the loading port structure 14, the rotatable container shelf 31 and the transport structure 86 on the display 82D, it is possible to easily grasp the states of the wafers 1 in the container 2.

Further, according to the substrate processing apparatus 10 of the present embodiments, by displaying the states of the containers 2 in each of the loading port structure 14, the rotatable container shelf 31 and the transport structure 86 on the display 82D, it is possible to visually check the state of the container 2.

Further, according to the substrate processing apparatus 10 of the present embodiments, by displaying the state of the loading port structure 14 on the display 82D, it is possible to easily grasp whether the loading port structure 14 can be used or not by a visual inspection.

Further, according to the substrate processing apparatus 10 of the present embodiments, by displaying the icons 94 in a different manner, it is possible to more definitely identify the states of the wafers 1 in the container 2 as compared with a text display.

Further, according to the method of manufacturing the semiconductor device of the present embodiments, regardless of the usage state of the transport structure 86, the controller 77 causes the container transfer device 35 to hold the container 2 placed on the loading port structure 14. Thereby, it is possible to accept the placement of the subsequent container (among the containers 2) onto the loading port structure 14. As a result, it is possible to shorten the waiting time (stand-by time) for placing the container 2, and it is also possible to improve a substrate processing efficiency (that is, the processing efficiency of the wafers 1).

Further, according to the program included in the substrate processing apparatus 10 of the present embodiments, regardless of the usage state of the transport structure 86, the controller 77 causes the container transfer device 35 to hold the container 2 placed on the loading port structure 14. Thereby, it is possible to accept the placement of the subsequent container (among the containers 2) onto the loading port structure 14. As a result, it is possible to shorten the waiting time (stand-by time) for placing the container 2, and it is also possible to improve the substrate processing efficiency (that is, the processing efficiency of the wafers 1).

### <Modified Example>

While the technique of the present disclosure is described in detail by way of the embodiments mentioned above, the technique of the present disclosure is not limited thereto. The technique of the present disclosure may be modified in various ways without departing from the scope thereof.

For example, the embodiments mentioned above are described by way of an example in which the CPU 80A of the controller 77 performs each procedure by performing (executing) the program. However, the program according to the present embodiments may be executed by a computer included in an external apparatus (not shown) instead of the controller 77. In such a case, the computer may execute the same procedure as described above by controlling the controller 77 via the external communication interface 82A.

Further, the program according to the present embodiments may be prepared by being recorded on a nonvolatile recording medium and appropriately installed in the substrate processing apparatus 10 via the external memory 82B. For example, as the nonvolatile recording medium, a medium such as a CD-ROM, a magneto-optical disk, a hard disk drive (HDD), a DVD-ROM, a flash memory, a memory card and a USB may be used.

For example, in consideration of the airtightness of the container storage chamber 11b and the prevention of particles scattering outside the apparatus, it is preferable to provide the front shutter 13 or to set the container loading/unloading port 12 with a small opening size. However, the front shutter 13 may not be provided.

Alternatively, the container loading/unloading port 12 may be formed as large as possible to substantially open almost an entirety of the partition wall above the housing (which is sealed).

For example, the support table 18 (top plate) is elevated in advance by the container elevator 35a to a height position accessible by the container transfer device 35 and the container 2 is received from the OHT at such a height position to the support table 18. Then, the container 2 may be received from the support table 18 by the container transfer device 35 without lowering the support table 18 to perform an opening or closing operation of the door 4.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of simultaneously processing one or several substrates is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film. Further, the technique of the present disclosure is not limited thereto. For example, the technique of the present disclosure may be applied to another substrate processing apparatus such as a diffusion apparatus, an annealing apparatus and an oxidation apparatus.

The process sequences and the process conditions of each process using the substrate processing apparatuses exemplified above may be substantially the same as those of the embodiments or modified examples mentioned above. Even in such a case, it is possible to obtain substantially the same effects as in the embodiments or the modified examples mentioned above.

The substrate is not limited to the wafer described above. For example, a structure such as a photomask, a printed wiring substrate, a liquid crystal panel, a compact disk and a magnetic disk may be used as the substrate.

The invention may be summarized as follows: To accept a subsequent container regardless of a usage state of a transport structure and thereby to improve a transfer efficiency of a container, there is provided a technique that includes: a mounting structure on which a container provided with a door is placed; a storage structure for storing the container; a processing structure; a transport structure for transporting a substrate to the processing structure and including: an opening/closing structure opening or closing the door; and a checker for checking a state of the substrate in the container; a transfer structure for holding the container and transferring the container to the mounting structure, the storage structure and the transport structure; and a controller for controlling the transfer structure to hold the container on the mounting structure and the mounting structure to accept a placement of a subsequent container, regardless of a usage state of the transport structure.

While the embodiments of the present disclosure are described above with reference to the drawings, it is apparent to those skilled in the art that the technique of the present disclosure may be modified to obtain various modified examples and applications within the scope of the technical idea described in the claims. It is also apparent to those skilled in the art that various modified examples and applications described above also fall within the technical scope of the present disclosure.

### [Description of Reference Numerals]

- 1:: wafer (an example of a substrate)
- 2:: container
- 4:: door
- 10:: batch type CVD apparatus (an example of a substrate processing apparatus)
- 14:: loading port structure (an example of a mounting structure)
- 27:: mapping device (an example of a confirmation structure)
- 31:: rotatable container shelf (an example of a storage structure)
- 35:: container transfer device (an example of a conveyance structure)
- 42:: container opener (an example of opening/closing structure)
- 51:: process furnace (an example of a processing structure)
- 77:: controller
- 86:: transport structure

## Claims

1. A substrate processing apparatus comprising:
a mounting structure on which a container provided with a door is placed, wherein the container is configured to accommodate a substrate;
a storage structure configured to store the container;
a processing structure configured to process the substrate;
a transport structure configured to transport the substrate to the processing structure and comprising:
an opening/closing structure configured to open or close the door; and
a checker configured to check a state of the substrate accommodated in the container;
a transfer structure configured to hold the container and to transfer the container to the mounting structure, the storage structure and the transport structure; and
a controller configured to be capable of controlling the transfer structure to hold the container placed on the mounting structure and capable of controlling the mounting structure to accept a placement of a subsequent container, regardless of a usage state of the transport structure.

2. The substrate processing apparatus of claim 1, wherein the controller is configured to be capable of controlling the transfer structure to designate a transfer destination of the container held by the transfer structure to one selected from the group of the storage structure, the transport structure and the mounting structure.

3. The substrate processing apparatus of claim 1 and/or 2, wherein the controller is configured to be capable of controlling the transfer structure to store the container placed on the mounting structure in the storage structure when the transport structure is unavailable.

4. The substrate processing apparatus of any one or more of claims 1 to 3, wherein the controller is configured to be capable of controlling the transfer structure to transfer the container stored in the storage structure to the transport structure when the transport structure is available.

5. The substrate processing apparatus of any one or more of claims 1 to 4, wherein the controller is configured to be capable of controlling the transfer structure to transfer the container placed on the mounting structure to the transport structure when the transport structure is available.

6. The substrate processing apparatus of any one or more of claims 1 to 5, wherein the controller is configured to be capable of controlling the transfer structure and the mounting structure such that the placement of the subsequent container to the mounting structure is not accepted until the transfer structure holds the container placed on the mounting structure.

7. The substrate processing apparatus of any one or more of claims 1 to 6, further comprising
an external communication interface capable of communicating with an external equipment,
wherein the controller is connected to the external equipment via the external communication interface, and
wherein a placement acceptance state of the container to the mounting structure is to be reported to the external equipment from the controller.

8. The substrate processing apparatus of claim 7, wherein the controller is configured to be capable of reporting the usage state of the transport structure to the external equipment.

9. The substrate processing apparatus of claim 7 and/or 8, wherein the controller is configured to be capable of transferring the container from the mounting structure to the storage structure without waiting for a response from the external equipment with respect to a report of the usage state of the transport structure.

10. The substrate processing apparatus of any one or more of claims 1 to 9, further comprising
a display capable of displaying at least one selected from the group of state information of the mounting structure, a storage position of the container and state information of the container.

11. The substrate processing apparatus of claim 10, wherein the state information of the container comprises at least one item selected from the group of a presence or absence of the substrate in the container, a type of the substrate, a result of checking the state of the substrate and whether or not a processing is capable of being performed, and
wherein the display is capable of displaying the at least one item related to the container.

12. The substrate processing apparatus of claim 10 and/or 11, wherein the state information of the mounting structure comprises at least one item selected from the group of whether or not the mounting structure is capable of being used, a usage state of the mounting structure and whether or not the container is placed on the mounting structure, and
wherein the display is capable of displaying the at least one item related to the mounting structure.

13. A transfer method comprising:
(a) placing a container provided with a door and accommodating a substrate therein onto a mounting structure;
(b) transferring the container to a transport structure configured to open or close the door and configured to check a state of the substrate; and
(c) holding the container placed on the mounting structure onto a transfer structure and accepting a placement of a subsequent container onto the mounting structure, regardless of a usage state of the transport structure.

14. A method of manufacturing a semiconductor device, comprising:
the transfer method of claim 13; and
processing the substrate in a process chamber.

15. A program that causes, by a computer, a substrate processing apparatus to perform:
(a) placing a container provided with a door and accommodating a substrate therein onto a mounting structure;
(b) transferring the container to a transport structure configured to open or close the door and configured to check a state of the substrate; and
(c) holding the container placed on the mounting structure onto a transfer structure and accepting a placement of a subsequent container onto the mounting structure, regardless of a usage state of the transport structure.
